# EUROPEAN PATENT APPLICATION

(11) **EP 2 154 941 A1**
(43) Date of publication of application: **17.02.2010**
(21) Application number: 08752116.7
(22) Date of filing: 25.04.2008
(51) Int. Cl.: H05K 13/04

(54) **VACUUM SUCTION NOZZLE**

(30) Priority: 25.04.2007 JP 2007115441
(71) Applicant: Kyocera Corporation, Kyoto-shi Kyoto 612-8501 (JP)
(72) Inventor: HAMASHIMA, Hiroshi, Satsumasendai-shi Kagoshima 895-0292 (JP)
(74) Representative: HOFFMANN EITLE
(86) International application number: PCT/JP2008/058042
(87) International publication number: WO 2008/133324

(57) **Abstract**

When a vacuum suction nozzle moves at a high speed for transferring an electronic component, static electricity is generated due to friction with air. There has been such a problem that when the electrostatically charged vacuum suction nozzle is brought close to the electronic component, the electronic component is sometimes blown by a repulsion force of static electricity. There has been also a possibility of destroying the electronic component due to electric discharge. A vacuum suction nozzle (1) is provided with a suction surface (2) for sucking a sucking object by vacuum; a rear end surface (8) facing the suction surface (2); and a suction hole (3) penetrating to the rear end surface (8) from the suction surface (2). The vacuum suction nozzle (1) has a resistance value of 10³- 10¹¹ Ω between the suction surface (2) and the rear end surface (8). Since the vacuum suction nozzle (1) has the suitable resistance value, generated static electricity can be removed to the external, and electric discharge does not easily generated.

## Description

### Technical Field

The present invention relates to a vacuum suction nozzle for vacuum-sucking an electronic component for use in an electronic component mounting device that mounts a chip-like electronic component on a circuit board.

### Background Art

Hitherto, an electronic component mounting apparatus including an electronic component mounting device has been used to mount chip-like electronic components such as chip capacitors and chip resistors on a circuit board.
The electronic component mounting device vacuum-sucks an electronic component with a vacuum suction nozzle, transports it to the circuit board, and mounts it at a predetermined position of the circuit board.

The electronic component mounting apparatus further includes a measurement optical system for check the position of the electronic component in order to accurately mount an electronic component at a predetermined position. The measurement optical system includes a lighting device, a CCD camera, and an imaging device connected to the CCD camera. The electronic component is irradiated with light from the lighting device. The CCD camera receives reflected light from the electronic component. The resulting image captured by the CCD camera is analyzed by an image analysis device to measure the shape of the electronic component and positions of electrodes of the electronic component.

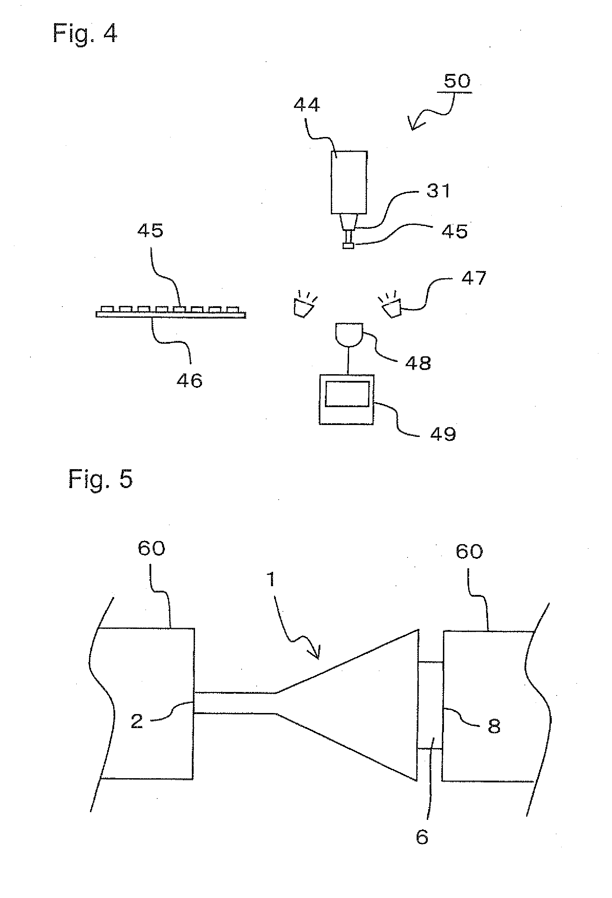

Fig. 4 is a schematic view illustrating the structure of an electronic component mounting apparatus 50 including an electronic component mounting device 44 equipped with a vacuum suction nozzle 31 and an measurement optical system.
The vacuum suction nozzle 31 is fixed to the electronic component mounting device 44.
The measurement optical system includes lights 47, a CCD camera 48, and an image analysis device 49 connected to the CCD camera 48. The lights 47 emit light to one electronic component 45 sucked by the vacuum suction nozzle 31. The CCD camera 48 receives reflected light (image) from the electronic component 45. The reflected light received by the CCD camera 48 is subjected to image processing by the image analysis device 49.
The electronic components 45 are arranged on a tray 46 and placed in the vicinity of the electronic component mounting apparatus 50.

In the case where the electronic component mounting apparatus 50 is operated, the electronic component mounting device 44 is transferred to the tray 46, and then the vacuum suction nozzle 31 sucks the electronic component 45 on the tray 46. The lights 47 irradiate the electronic component 45 sucked by the vacuum suction nozzle 31 with light. Light reflected from a main body and electrodes of the electronic component 45 is received by the CCD camera 48.
An image captured by the CCD camera 48 is analyzed by the image analysis device 49 to determine the precise position of the electronic component 45. Then the vacuum suction nozzle 31 that sucks the electronic component 45 is transferred to a circuit board (not shown). The electronic component 45 is placed on a predetermined position on the circuit board using the position data of the electronic component 45 obtained by the analysis. Then the electronic component 45 is mounted on the circuit board.

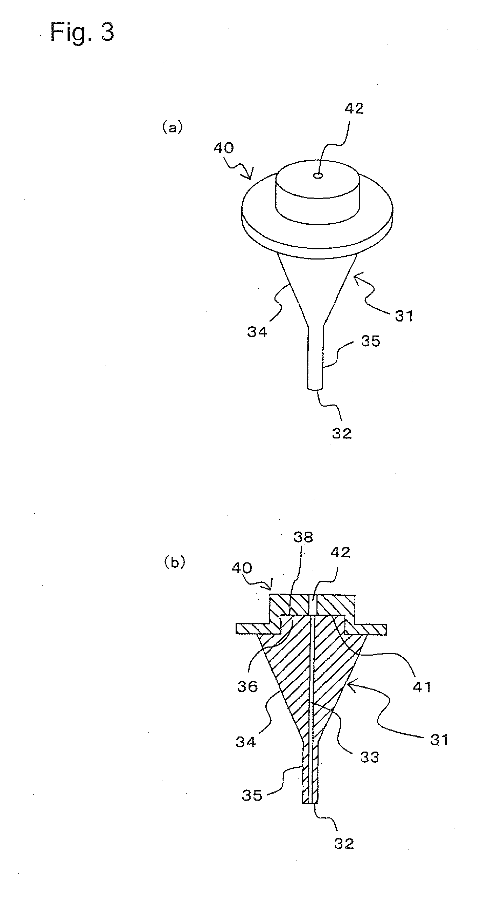

Fig. 3 shows the vacuum suction nozzle 31 of the related art and a holding member 40 of the electronic component mounting device 44. Fig. 3(a) is a perspective view of the vacuum suction nozzle 31. Fig. 3(b) is a longitudinal sectional view of the vacuum suction nozzle 31.

The vacuum suction nozzle 31 includes a suction face 32 that vacuum-sucks an electronic component and a rear end face 38 opposite the suction face 32. The vacuum suction nozzle 31 includes a cylindrical member (cylindrical portion 35) on the suction face 32 side. The vacuum suction nozzle 31 includes a conical member (conical portion 34) on the rear end face 38 side, the conical member tapering to the suction face 32. Furthermore, a projecting portion 36 is provided on the rear end face 38 side of the conical portion 34. The vacuum suction nozzle 31 includes a suction hole 33 extending from the suction face 32 to the rear end face 38 through the cylindrical portion 35, the conical portion 34, and the projecting portion 36.
The vacuum suction nozzle 31 is composed of a ceramic material or hard metal having good wear resistance.

The holding member 40 to which the vacuum suction nozzle 31 is fixed includes a recessed portion 41 into which the projecting portion 36 of the vacuum suction nozzle 31 fits in the middle of the holding member 40. A suction hole 42 is arranged in the central portion of the recessed portion 41 corresponding to the suction hole 33.
In fact, the holding member 40 is fixed on the electronic component mounting device 44. Thus, the attachment of the vacuum suction nozzle 31 to the holding member 40 results in the fixation of the vacuum suction nozzle 31 to the electronic component mounting device 44.

With respect to the vacuum suction nozzle 31, for example, Patent Document 1 discloses that a ceramic material having good wear resistance is used for a front end portion of the suction nozzle that sucks a chip component. Patent Document 1 also discloses that the color of the front end portion of the suction nozzle is set to a color of a low level of an input image compared with the color of the chip component so as to increase a contrast between the front end portion of the suction nozzle and a chip component when shooting is performed with a camera. Thereby, the position of the chip component can be detected. This suction nozzle advantageously has good wear resistance and makes it possible to assuredly perform image processing of the chip component picked up by the suction nozzle.

Patent Document 2 discloses a sintered ceramic body suited to produce a member for use in semiconductor-manufacturing equipment. The ceramic sintered body contains cordierite as a main component and contains Ti and at least one element selected from La, Ce, Pr, and Nd, which are rare-earth elements. It is possible to obtain a ceramic sintered body having a volume resistivity of 1 × 10⁵ Ω·m to 1 × 10¹² Ω·m because Ti and the rare-earth elements of La, Ce, Pr, and Nd are conductive. Furthermore, the cordierite as a main component has a low thermal expansion; hence, the ceramic sintered body is not readily deformed by thermal expansion. In the case where a member (e.g., an electrostatic chuck or vacuum chuck) for use in semiconductor-manufacturing equipment that is used to produce a semiconductor wafer is formed of the ceramic sintered body having these physical properties, the adhesion of dust to the member is prevented, and the deformation of the member due to an increase in temperature is suppressed. It is thus possible to produce a semiconductor wafer having good dimensional accuracy.
Patent Document 1: Japanese Unexamined Patent Application Publication No. 2-90700
Patent Document 2: Japanese Unexamined Patent Application Publication No. 2004-196589

### Disclosure of Invention

### Problems to be Solved by the Invention

Currently, however, a high-speed travel of a vacuum suction nozzle of a electronic component mounting apparatus between a tray and a circuit board may generate static electricity by friction between the vacuum suction nozzle and air (or dust in air), thus charging the vacuum suction nozzle. Furthermore, the repetition of attachment and detachment of the electronic components may generate static electricity, thus charging the vacuum suction nozzle. When the charged vacuum suction nozzle approaches the electronic components, electrostatic repulsion is generated therebetween. Current electronic components are small and lightweight; hence, the electronic components are disadvantageously blown off a predetermined position of a tray by the repulsion. Thus, it is difficult to appropriately transport the electronic components from the tray to a circuit board by the electronic component mounting apparatus.

Usually, a plurality of electronic components and associated components are mounted on one circuit board. Furthermore, the packing density of the components is being increased every year. Thus, when an electronic component sucked by the vacuum suction nozzle is arranged on a circuit board, the vacuum suction nozzle (in particular, the suction face of the vacuum suction nozzle) is likely to come into contact with mounted electronic components and associated components. As a result, the mounted electronic components are disadvantageously damaged.

However, Patent Documents 1 and 2 do not describe that the vacuum suction nozzle is electrostatically charged or electronic components are blown off by the charged vacuum suction nozzle. Furthermore, Patent Documents 1 and 2 do not describe or suggest a possibility of damaging to mounted electronic components and the like by the vacuum suction nozzle or its solving method.

It is an object of the present invention to provide a vacuum suction nozzle capable of solving the problem of the blowing off of the electronic components due to an electrostatically charged vacuum suction nozzle. It is another object of the present invention to provide a vacuum suction nozzle capable of solving the problem in which mounted other electronic components and the like are damaged when the electronic components are mounted.

### Means for Solving the Problems

According to the present invention, a vacuum suction nozzle composed of a ceramic material includes a suction face, a rear end face opposite the suction face, and a suction hole extending from the suction face to the rear end face, in which the vacuum suction nozzle has a resistance of 10³ to 10¹¹ Ω between the suction face and the rear end face.

Since the vacuum suction nozzle has a resistance of 10³ to 10¹¹ Ω between the suction face and the rear end face, it is possible to remove static electricity generated on the vacuum suction nozzle to the outside (for example, electronic component mounting device to which the vacuum suction nozzle is attached). It is thus possible to suppress the problems in which objects such as electronic components to be sucked are moved or blown off when the vacuum suction nozzle approaches the objects to be sucked.

### Advantages

The vacuum suction nozzle of the present invention can solve the problem in which the electronic component is blown off by a charged vacuum suction nozzle and the problem in which mounted other electronic components are damaged when the electronic components are mounted.

### Brief Description of Drawings

[Fig. 1] Fig. 1 shows a vacuum suction nozzle of the present invention. Fig. 1(a) is a schematic perspective view of a vacuum suction nozzle to which a holding member is fixed. Fig. 1(b) is a schematic longitudinal sectional view of the vacuum suction nozzle. Fig. 1(c) is an enlarged schematic view of portion E shown in Fig. 1(b). Fig. 1(d) is an enlarged schematic view of portion F shown in Fig. 1(b).
[Fig. 2] Fig. 2 is a schematic view illustrating the structure of an electronic component mounting apparatus including a vacuum suction nozzle of the present invention.
[Fig. 3] Fig. 3 shows a vacuum suction nozzle of the related art. Fig. 3 (a) is a schematic perspective view of a vacuum suction nozzle to which a holding member is fixed. Fig. 3 (b) is a schematic longitudinal sectional view of the vacuum suction nozzle.
[Fig. 4] Fig. 4 is a schematic view illustrating the structure of an electronic component mounting apparatus including a vacuum suction nozzle of the related art.
[Fig. 5] Fig. 5 is a schematic view illustrating a method for measuring the resistance between a suction face and a rear end face of a vacuum suction nozzle.
[Fig. 6] Fig. 6 is a schematic view illustrating a chip generated when a suction face of a vacuum suction nozzle is subjected to grinding.

### Reference Numerals

- 1: vacuum suction nozzle
- 2: suction face
- 3: suction hole
- 4: conical portion
- 5: cylindrical portion
- 6: projecting portion
- 7: conductive layer
- 8: rear end face
- 10: holding member

### Best Modes for Carrying Out the Invention

Embodiments of the present invention will be described below.

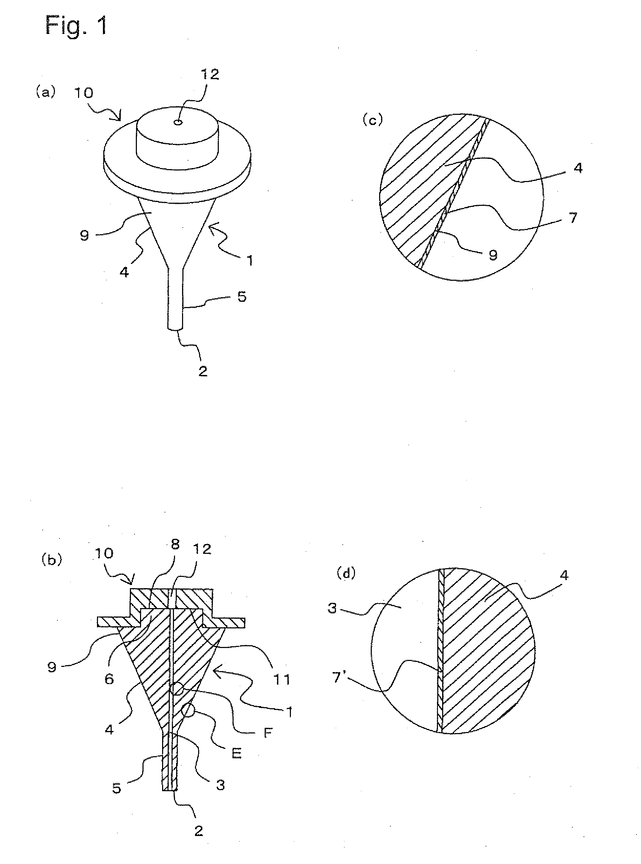

Fig. 1 shows a vacuum suction nozzle 1 and a holding member 10, according to the present invention, that is retained on an electronic component mounting device by chucking or the like. Fig. 1(a) is a perspective view of the vacuum suction nozzle 1. Fig. 1(b) is a longitudinal sectional view of the vacuum suction nozzle 1.

The vacuum suction nozzle 1 includes a suction face 2 that vacuum-sucks an object (e.g., an electronic component) and a rear end face 8 opposite the suction face 2. The vacuum suction nozzle 1 includes a cylindrical member (cylindrical portion 5) on the suction face 2 side. The vacuum suction nozzle 1 includes a conical member (conical portion 4) on the rear end face 8 side, the conical member tapering to the suction face 2. Furthermore, a projecting portion 6 is provided on the rear end face 8 side of the conical portion 4. The vacuum suction nozzle 1 includes a suction hole 3 extending from the suction face 2 to the rear end face 8 through the cylindrical portion 5, the conical portion 4, and the projecting portion 6.
The vacuum suction nozzle 1 is composed of a ceramic material.

The holding member 10 to which the vacuum suction nozzle 1 is fixed includes a recessed portion 11 into which the projecting portion 6 of the vacuum suction nozzle 1 fits in the middle of the holding member 10. A suction hole 12 is arranged in the central portion of the recessed portion 11 corresponding to the suction hole 3. In fact, the holding member 10 is retained on the electronic component mounting device (not shown) by chucking. Thus, the attachment of the vacuum suction nozzle 1 to the holding member 10 results in the placement of the vacuum suction nozzle 1 on the electronic component mounting device.

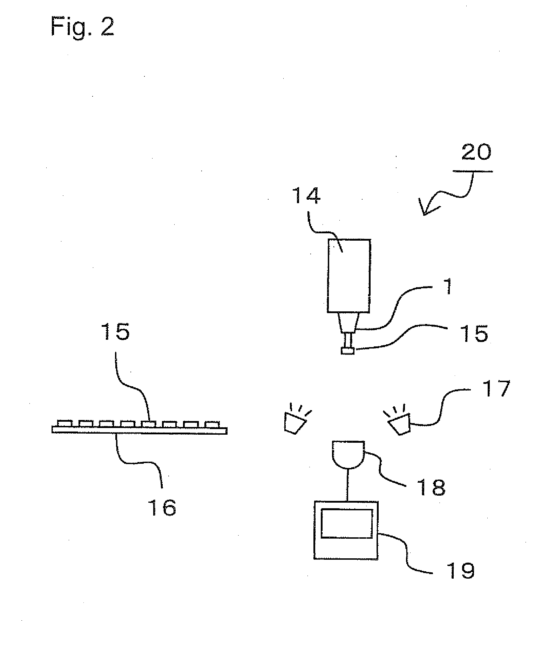

Referring to Fig. 2, an electronic component mounting apparatus 20 including the vacuum suction nozzle 1 will be described.
Fig. 2 is a schematic view illustrating the structure of an electronic component mounting device 14 including the vacuum suction nozzle 1 and the electronic component mounting apparatus 20 including a measurement optical system. The vacuum suction nozzle 1 is fixed to the electronic component mounting device 14. The measurement optical system includes lights 17, a CCD camera 18, and an image analysis device 19 connected to the CCD camera 18. The lights 17 emit light to one electronic component 15 sucked by the vacuum suction nozzle 1. The CCD camera 18 receives reflected light (image) from the electronic component 15. The reflected light received by the CCD camera 18 is subjected to image processing by the image analysis device 19.
The electronic components 15 are arranged on a tray 16 and placed in the vicinity of the electronic component mounting apparatus 20.

In the case where the electronic component mounting apparatus 20 is operated, the electronic component mounting device 14 is transferred to the tray 16, and then the vacuum suction nozzle 1 sucks the electronic component 15 on the tray 16. The lights 17 irradiate the electronic component 15 sucked by the vacuum suction nozzle 1 with light. Light reflected from a main body and electrodes of the electronic component 15 is received by the CCD camera 18. An image captured by the CCD camera 18 is analyzed by the image analysis device 19 to determine the precise position of the electronic component 15. Then the vacuum suction nozzle 1 that sucks the electronic component 15 is transferred to a circuit board (not shown). The electronic component 15 is placed on a predetermined position on the circuit board using the position data of the electronic component 15 obtained by the analysis. Then the electronic component 15 is mounted on the circuit board.

In the vacuum suction nozzle 1 of the present invention, the resistance between the suction face 2 and the rear end face 8 (referred to as "resistance of the vacuum suction nozzle" in this specification) is in the range of 10³ to 10¹¹ Ω, so that static electricity generated on the vacuum suction nozzle 1 can be removed (grounded) to the electronic component mounting device 14 through the rear end face 8. It is thus possible to suppress problems in which the electronic component 15 is moved or blown off when the vacuum suction nozzle 1 approaches the electronic component 15.

The operation and effect of the vacuum suction nozzle 1 of the present invention will be described in detail below.

With respect to the vacuum suction nozzle 1, static electricity generated on the vacuum suction nozzle 1 can be removed to the electronic component mounting device 14 by electrical connection to the electronic component mounting device 14 through the holding member 10 (see Fig. 1). Thus, even when the vacuum suction nozzle 1 approaches the electronic components 15 on the tray 16, electrostatic repulsion does not occur between the vacuum suction nozzle 1 and the electronic components 15. It is thus possible to suppress the blowing off of the electronic components 15 when the vacuum suction nozzle 1 approaches the electronic components 15.

In the case of a resistance of the vacuum suction nozzle 1 of less than 10³ Ω, the conductivity is excessively high. If a member (for example, a table on which a circuit board is placed) around the vacuum suction nozzle 1 is charged, thus, discharge is likely to occur from the member to a front end portion (near the suction face 2) of the vacuum suction nozzle 1. If discharge occurs toward the front end portion of the vacuum suction nozzle 1 when the electronic components 15 is sucked on the suction face 2 of the vacuum suction nozzle 1, the electronic components 15 may be damaged by electrostatic discharge. In particular, electronic components such as IC with a low withstand voltage is prone to damage by electrostatic discharge. It is thus important to suppress discharge. Hence, the resistance is preferably 10³ Ω or more.

In the case of a resistance of the vacuum suction nozzle 1 exceeding 10¹¹ Ω, static electricity is not readily removed from the vacuum suction nozzle 1 to the electronic component mounting device 14. That is, the vacuum suction nozzle 1 is liable to be charged. When the vacuum suction nozzle 1 approaches the electronic components 15, thus, the electronic components 15 are likely to be blown off because of electrostatic repulsion. The resistance, therefore, is preferably 10¹¹ Ω or less.

Furthermore, if the vacuum suction nozzle 1 is charged, discharge is likely to occur from the front end portion of the vacuum suction nozzle 1 to the member around the vacuum suction nozzle 1. Discharge from the front end portion of the vacuum suction nozzle 1 to, for example, the electronic components 15 to be sucked or an electric component that has been mounted on a circuit board, the electronic components 15 or the like may be damaged by electrostatic discharge. However, a resistance of the vacuum suction nozzle 1 of 10¹¹ Ω or less results in the suppression of the charge of the vacuum suction nozzle 1, thus suppressing the damage to, for example, the electronic components 15 by electrostatic discharge.

The shape of the suction face 2 is typically circular. Alternatively, the shape of the suction face 2 may be any shape, e.g., elliptic, rectangular, or polygonal, in response to the shape of the electronic components 15 to be sucked.

The suction face 2 of the vacuum suction nozzle 1 preferably has a maximum dimension of 0.7 mm or less in at least one of a first direction and a second direction orthogonal to the first direction. That is, in the vacuum suction nozzle 1, at least one of the maximum dimension of the first direction (referred to as "dimension M1") and the maximum dimension of the second direction (referred to as "dimension M2") may be 0.7 mm or less. For example, in the case where dimension M1 is 0.7 mm or less, dimension M2 may be larger than 0.7 mm.

Here, the "first direction" and the "second direction" vary depending on the shape of the suction face 2. For example, in the case where the suction face 2 is elliptic, the direction of the minor axis is defined as the first direction, and the direction of the major axis is defined as the second direction. In the case where the suction face 2 is rectangular, the direction of the short side is defined as the first direction, and the direction of the long side is defined as the second direction. In the case where the suction face 2 is square, any of two sides perpendicular to each other is defined to the first direction or the second direction. In the case where the suction face 2 is circular, any direction through the center is defined as the first direction, and a direction perpendicular to the first direction is defined as the second direction. That is, in the case where the suction face 2 is circular, dimensions M1 and M2 is equal to the diameter.

In the case where dimension M1 and/or dimension M2 of the suction face 2 of the vacuum suction nozzle 1 is 0.7 mm or less, the suction face 2 of the vacuum suction nozzle 1 is less likely to come into contact with a mounted electronic component or the like when the electronic component 15 is mounted on a circuit board. It is thus possible to suppress damage to the mounted electronic component or the like by the contact with the vacuum suction nozzle 1. Furthermore, it is possible to suppress damage to the suction face 2 of the vacuum suction nozzle 1 by the contact with the mounted electronic component or the like.

If both dimensions M1 and M2 of the suction face 2 of the vacuum suction nozzle 1 exceed 0.7 mm, the suction face 2 is more likely to come into contact with an electronic component or the like mounted on a circuit board. For example, in recent years, very small electronic components 15 each having a side of 1 mm or less (e.g., referred to as 0603-type electronic components (dimensions: 0.6 mm × 0.3 mm)) have sometimes been mounted on circuit boards so as to be spaced at about 0.1 to about 0.2 mm. That is, the spacing between mounted electronic components is sometimes as small as about 0.8 mm at a position where the electronic component 15 is mounted. Thus, if the dimension of the suction face 2 of the vacuum suction nozzle 1 exceeds 0.7 mm, the suction face 2 of the vacuum suction nozzle 1 is more likely to come into contact with the mounted electronic component and the like. In particular, in the case where the electronic components 15 is sucked by the vacuum suction nozzle 1, even slight (e.g., 0.1 mm) displacement of the position of the electronic component 15 from an optimum position with respect to the suction face 2 will bring the suction face 2 of the vacuum suction nozzle 1 into contact with, for example, the mounted electronic component. This result in the risk of damage to, for example, the mounted electronic component and chipping of the suction face 2 of the vacuum suction nozzle 1.
Thus, dimensions M1 and M2 of the suction face 2 of the vacuum suction nozzle 1 are preferably 0.7 mm or less.

In the case where only one (e.g., dimension M1 only) of dimensions M1 and M2 of the suction face 2 of the vacuum suction nozzle 1 is 0.7 mm or less, the vacuum suction nozzle 1 may be used in such a manner that a direction of smaller spacing between the mounted electronic components accords with the first direction (direction of measurement of dimension M1), thereby avoiding the contact of the mounted electronic components and the suction face 2 of the vacuum suction nozzle 1. Furthermore, in the case where one dimension (e.g., dimension M2) exceeds 0.7 mm, the cylindrical portion 5 has increased mechanical strength, which is preferable.

The vacuum suction nozzle 1 of the present invention is composed of a ceramic material that advantageously has good wear resistance. Thus, even the repetition of attachment and detachment of the electronic components 15 does not readily cause the suction face 2 of the vacuum suction nozzle 1 to wear out. The wearing out of the suction face 2 causes a gap between the suction face 2 and a corresponding one of the electronic components 15, thereby reducing a vacuum suction force. Thus, the vacuum suction nozzle 1 needs to be replaced. The vacuum suction nozzle 1 of the present invention can suppress the wearing for prolonged periods of time and thus has a long operating lifetime.

Here, a method for measuring the resistance of the vacuum suction nozzle 1 will be described.
Fig. 5 is an explanatory drawing illustrating a method for measuring the resistance of the vacuum suction nozzle 1. To measure the resistance, two electrodes 60 facing each other and a device for measuring electrical resistance (not shown) are used. First, one of the electrodes 60 is brought into contact with the suction face 2 of the vacuum suction nozzle 1, and the other electrode 60 is brought into contact with the rear end face 8 (end face of the projecting portion 6). Then the resistance between the suction face 2 and the rear end face 8 of the vacuum suction nozzle 1 is measured with the device for measuring electrical resistance. The device for measuring electrical resistance can measure the resistance by application of any voltage. Thus, an applied voltage can be adjusted in response to, for example, the shape and material of the vacuum suction nozzle 1. For the vacuum suction nozzle 1 of the present invention, the measurement is suitably performed at a voltage of about 10 to about 1500 V.

In particular, the vacuum suction nozzle 1 more preferably has a resistance of 10⁵ to 10⁸ Ω. The vacuum suction nozzle 1 with a resistance within the above range is extremely suitable for use in the electronic component mounting apparatus 20 that can achieve high-speed mounting. The reason for this will be described in detail below.

To increase the mounting speed of the electronic components 15, it is desirable to use the electronic component mounting apparatus 20 that can achieve high-speed mounting. To achieve high-speed mounting, however, it is necessary to reduce the time (for example, about 0.2 seconds or less) required for the attachment-detachment cycle of the electronic components 15 (time taken to suck a corresponding one of the electronic components 15 on the tray 16, place it on a circuit board, and suck the next electronic component 15 on the tray 16). Furthermore, the vacuum suction nozzle 1 is readily charged when sucks the electronic component 15 on the tray 16. The charged static electricity needs to be discharged by the time the vacuum suction nozzle 1 is transferred onto the circuit board. Furthermore, static electricity newly charged after the electronic component 15 is arranged on the circuit board needs to be discharged by the time the next electronic component 15 is sucked on the tray 16. Thus, static electricity generated on the vacuum suction nozzle 1 needs to be sufficiently removed in a short time until the electronic component 15 is sucked. That is, it is desirable to provide the vacuum suction nozzle 1 in which static electricity can efficiently be removed in a very short time.

Furthermore, to reduce the time taken to perform the attachment-detachment cycle, the vacuum suction nozzle 1 travels at high speed. A higher travel speed of the vacuum suction nozzle 1 results in an increase in the frictional resistance between the vacuum suction nozzle 1 and air, increasing the amount of static electricity generated by friction between the vacuum suction nozzle 1 and air. It is thus desirable to provide the vacuum suction nozzle 1 in which a larger amount of static electricity can be removed in a short period of time.

A resistance of the vacuum suction nozzle 1 of 10⁸ Ω or less permits the removal of an increased amount of static electricity in a very short time and is thus preferred. That is, even when the vacuum suction nozzle 1 having a resistance of 10⁸ Ω or less is used in the electronic component mounting apparatus 20 that can achieve high-speed mounting, it is possible to sufficiently suppress the electrostatic charging of the vacuum suction nozzle 1.

If the vacuum suction nozzle 1 has a resistance exceeding 10⁸ Ω, it is difficult to sufficiently remove static electricity during the attachment-detachment cycle having a duration of 0.2 seconds or less. Thus, electrostatic repulsion acting between the vacuum suction nozzle 1 and the electronic component 15 is likely to move the electronic component 15 when the vacuum suction nozzle 1 sucks the electronic component 15 on the tray 16. The electronic component 15 may be sucked by the vacuum suction nozzle 1 while the position of the electronic component 15 is being displaced from a target position with respect to the vacuum suction nozzle 1. In this case, the electronic component 15 may drop onto the circuit board because of an insufficient suction force. Furthermore, if a high electrostatic repulsion acts between the vacuum suction nozzle 1 and the electronic component 15, the electronic component 15 is likely to be blown off.
Thus, the upper limit of the resistance of the vacuum suction nozzle 1 is preferably 10⁸ Ω.

In the case where the lower limit of the resistance of the vacuum suction nozzle 1 is 10⁵ Ω, discharge from the member around the vacuum suction nozzle 1 to the front end portion of the vacuum suction nozzle 1 is further suppressed and is thus preferred. In particular, in the case where the electronic component 15 such as IC with a low withstand voltage is sucked and transferred, it is desirable to use the vacuum suction nozzle 1 having a resistance of 10⁵ Ω or more.

In the case of the vacuum suction nozzle 1 having a resistance of 10⁵ to 10⁸ Ω, the resistance is suitably measured at an applied voltage of 10 to 50 V. The vacuum suction nozzle 1 has high discharge efficiency. Thus, when the electronic component 15 is attached or detached, static electricity is almost removed. The voltage of static electricity in operation is believed to be up to about 50 V. Thus, to determine the resistance at a voltage close to a voltage in operation, the applied voltage may be set to 50 V or less. That is, it is believed that when the resistance at a voltage of 10 to 50 V is in the range of 10⁵ to 10⁸ Ω, the blowing off of the electronic component 15 and damage to the electronic component 15 by electrostatic discharge can be effectively suppressed.

The ceramic material used for the vacuum suction nozzle 1 preferably contains a conductivity-imparting material. In general, a ceramic material is an insulator. The addition of a conductivity-imparting material to the ceramic material can reduce the resistance of the ceramic material. Furthermore, the resistance can be adjusted by the type and amount of the conductivity-imparting material. Hence, the ceramic material containing the conductivity-imparting material is suited to produce the vacuum suction nozzle 1 suitable for the present invention.

For example, alumina (Al₂O₃) is an insulating ceramic material and has the advantages of inexpensiveness and good wear resistance. The addition of a conductivity-imparting material, such as titanium carbide (TiC) or titanium nitride (TiN), to the alumina ceramic material can reduce the resistance of the alumina ceramic material. That is, the alumina ceramic material containing, for example, titanium carbide or titanium nitride is suited to produce the vacuum suction nozzle 1 having good wear resistance.

Zirconia (ZrO₂) is also an insulating ceramic material and advantageous in that zirconia has high strength and can form a tough slender structure. The addition of a conductivity-imparting material such as iron oxide (Fe₂O₃) can reduce the resistance of the zirconia ceramic material. That is, the zirconia ceramic material containing, for example, iron oxide is suited to produce the vacuum suction nozzle 1 having an elongated front end portion.

Furthermore, silicon carbide (SiC) is a ceramic material having conductivity and good heat dissipation. However, the volume resistivity of silicon carbide is too high for use in the vacuum suction nozzle 1. Thus, the addition of a conductivity-imparting material such as carbon to the silicon carbide ceramic material can reduce the resistivity of the silicon carbide ceramic material. That is, the silicon carbide ceramic material containing carbon is suited to produce the vacuum suction nozzle 1 having good heat dissipation.

As shown in Fig. 1(c), a side face 9 of the vacuum suction nozzle 1 is preferably covered with a layer composed of a ceramic material containing a conductivity-imparting material or a layer composed of a conductivity-imparting material (these are collectively referred to as a "conductive layer 7"). The side face 9 of the vacuum suction nozzle 1 includes a side face of the conical portion 4 and a side face of the cylindrical portion 5.

In this way, covering the side face of the vacuum suction nozzle 1 with the conductive layer 7 results in removal of static electricity generated on the vacuum suction nozzle 1 through not only the vacuum suction nozzle 1 but also the conductive layer 7 and advantageously improves the removal efficiency of static electricity from the vacuum suction nozzle 1.

As shown in Fig. 1(d), furthermore, an inner wall of the suction hole 3 passing through the vacuum suction nozzle 1 is preferably covered with a conductive layer (conductive layer 7') as well as the side face 9 of the vacuum suction nozzle 1. When the electronic component 15 is vacuum-sucked, air flows through the suction hole 3; hence, static electricity is also generated by friction between the inner wall of the suction hole 3 and air. The conductive layer 7' covering the inner wall of the suction hole 3 is effective in efficiently removing the generated static electricity.

To remove static electricity through the conductive layers 7 and 7', preferably, the conductive layers 7 and 7' are electrically connected to the electronic component mounting device 14. For example, the conductive layers 7 and 7' are allowed to extend to the rear end face 8 of the vacuum suction nozzle 1 to be brought into contact with the holding member 10, thereby removing static electricity to the electronic component mounting device 14 through the holding member 10.

In this embodiment, the conductive layer 7 is composed of a ceramic material containing a conductivity-imparting material or a conductivity-imparting material. Examples of the ceramic material containing a conductivity-imparting material suitable for the conductive layer 7 include titanium carbide, alumina containing titanium nitride or the like, zirconia containing iron oxide, and silicon carbide containing carbon. Examples of the conductivity-imparting material suitable for the conductive layer 7 include titanium carbide, titanium nitride, silicon carbide, and carbon.

The conductive layer 7 can be formed by any of various methods. For example, the conductive layer 7 can be formed of a precipitate from the vacuum suction nozzle 1.
In the case where the conductive layer 7 is a precipitate from the vacuum suction nozzle 1, a clear boundary is not formed between the vacuum suction nozzle 1 and the conductive layer 7, so that the vacuum suction nozzle 1 can be strongly bonded to the conductive layer 7. As a result, the conductive layer 7 is not readily detached and improved in durability. Note that although the conductive layer 7 is formed by precipitating the conductivity-imparting material in the ceramic material constituting the vacuum suction nozzle 1, the whole of the conductivity-imparting material is not precipitated. That is, the conductivity-imparting material remains in the vacuum suction nozzle 1. Thus, static electricity generated on the vacuum suction nozzle 1 is removed through the vacuum suction nozzle 1 and the conductive layer 7.

In the case where the conductive layer 7 is formed of the precipitate, the amount of the conductivity-imparting material added to the ceramic material is desirably determined in consideration of a decrease in the amount of the conductivity-imparting material in the ceramic material due to precipitation. However, an excessively large amount of the conductivity-imparting material added to the ceramic material causes a reduction in the strength of the ceramic material. Thus, the amount of the conductivity-imparting material added to the ceramic material is preferably in the range of 10% by mass to 40% by mass. At an amount of the conductivity-imparting material added of less than 10% by mass, the conductivity-imparting material is not readily precipitated (in other words, the conductive layer 7 is not readily formed) and thus is not preferable. An amount added exceeding 40% by mass results in a reduction in the strength of the ceramic material and thus is not preferable.

Alternatively, the conductive layer 7 may be formed by coating.
The conductive layer 7 composed of any of various materials can be formed by coating the side face 9 of the vacuum suction nozzle 1 with a material constituting the conductive layer 7. Thus, the conductive layer 7 having desirable properties, e.g., conductivity, adhesion, flexibility, and sufficient durability, can be formed. In particular, the conductive layer 7 has the advantage over the conductive layer 7 formed by the precipitation method described above in that there is a very wide choice of materials that can be used for the conductive layer 7.

In the case where the conductive layer 7 is formed by coating, a material usable for the conductive layer 7 may be relatively freely selected. For example, selection of a material having good adhesion to the vacuum suction nozzle 1 is preferred because the conductive layer 7 is not readily detached. Furthermore, selection of a material having a low reactivity to the electronic component 15 transported is preferred because there is no risk of adversely affecting the electronic component 15. Typically, the conductive layer 7 can be composed of a ceramic material, for example, alumina, zirconia, or silicon nitride, or a conductivity-imparting material, for example, carbon, copper, chromium, nickel, titanium nitride, titanium carbide, or silicon carbide.

Examples of a method for forming the conductive layer 7 by coating include common known film-forming methods, such as a chemical vapor deposition (CVD) method, a physical vapor deposition (PVD) method, a plating method, and an application method.

For example, in the case of employing a chemical vapor deposition method, the vacuum suction nozzle 1 is placed in a reactor. A gas containing a coating material component (conductivity-imparting material) is introduced thereinto. Then the gas is reacted on a surface (side face 9) of the vacuum suction nozzle 1 to form the conductive layer 7. In particular, as a method for covering the inner wall of the suction hole 3 with the conductive layer 7', the chemical vapor deposition method is preferred.

In the case of employing a physical vapor deposition method, the vacuum suction nozzle 1 is placed in a vacuum chamber. A target composed of a coating material (conductivity-imparting material) is arranged so as to face the vacuum suction nozzle 1. Argon gas is charged into the vacuum chamber. The energy of discharge forms argon ions. The bombardment of the target with the argon ions evaporates atoms constituting the target. The atoms are deposited on the surface (side face 9) of the vacuum suction nozzle 1, thereby forming the conductive layer 7.

In the case of employing an application method, paint containing the conductivity-imparting material is applied to the surface (side face) of the vacuum suction nozzle 1 and dried or baked, thereby forming the conductive layer 7.
As the paint containing the conductivity-imparting material, a coating material containing a conductivity-imparting material dispersed in rubber or a resin as a base material may be used. The coating material is applied to the side face of the vacuum suction nozzle 1 and dried or cured, thereby forming the conductive layer 7.

In the case of employing a plating method, in general, an electroplating method is suitable. The conductivity of the vacuum suction nozzle 1 composed of a ceramic material, however, is not so high; hence, it is difficult to form a film by electroplating. Thus, a conductive base is formed on the side face of the vacuum suction nozzle 1 by electroless plating in advance. Electroplating can be performed by energizing the conductive base.
In the electroplating method, the vacuum suction nozzle 1 is immersed in a plating bath in which ions of the conductivity-imparting material are dissolved. A metal plate through which a current flows is connected to a positive electrode. The conductive base on the vacuum suction nozzle 1 is connected to a negative electrode, and then a current is allowed to flow. Thereby, the conductive layer 7 can be formed on the side face of the vacuum suction nozzle 1.

Note that a boundary is formed between the conductive layer 7 formed by coating and the vacuum suction nozzle 1. Thus, the conductive layer 7 formed by coating is liable to be detached, compared with the conductive layer 7 formed by precipitation. In particular, if the vacuum suction nozzle 1 is deformed, detachment or cracking is liable to occur. The vacuum suction nozzle 1 of the present invention, however, is composed of a ceramic material that is not readily deformed; hence, the risk of the occurrence of detachment or cracking of the conductive layer 7 seems to be relatively low.

The ceramic material used for the vacuum suction nozzle 1 is preferably a black ceramic material.
The electronic component 15 sucked by the vacuum suction nozzle 1 is irradiated with light from the lights 17. An image thereof is captured with the CCD camera 18. The resulting bright image of the electronic component 15 is displayed. Since the vacuum suction nozzle 1 composed of the black ceramic material is arranged behind the electronic component 15, the outline of the electronic component 15 is clearly captured. Thus, the image analysis device 19 can accurately recognize the shape of the electronic component 15, thereby advantageously improving position accuracy on arranging the electronic component 15 on a circuit board.

Examples of the black ceramic material include zirconia, alumina, and silicon carbide containing a black conductivity-imparting material.

The vacuum suction nozzle 1 may be formed of a ceramic material of a chromatic color. In particular, a ceramic material of a dark color such as brown or blue may provide the same effect as the black ceramic material. With respect to the color (hue, lightness, and color saturation) of the ceramic material used for the vacuum suction nozzle 1, an optimal color is preferably selected in response to the color of the electronic component 15. That is, the color of the ceramic material used for the vacuum suction nozzle 1 is preferably determined in such a manner that a clear outline of the electronic component 15 is obtained when the electronic component 15 is photographed with the CCD camera 18. In general, in the case where the color of the vacuum suction nozzle 1 is darker than the color of the electronic component 15, it is easy to distinguish between the vacuum suction nozzle 1 and the electronic component 15.
Use of the vacuum suction nozzle 1 of a proper color results in a clear outline of the electronic component 15 photographed with the CCD camera 18. As a result, an error of analysis by the image analysis device 19 is reduced, thereby improving position accuracy on arranging the electronic component 15 on a circuit board.

As described above, in the case where the vacuum suction nozzle 1 is composed of the ceramic material containing a conductivity-imparting material, the color of the ceramic material can be changed by the type of conductivity-imparting material added.

For example, to obtain a dark colored ceramic material, a conductivity-imparting material containing at least one of iron oxide, cobalt oxide, chromium oxide, and nickel oxide may be added. When the ceramic material contains iron oxide, the color of the ceramic material is a dark black color. When the ceramic material contains cobalt oxide, the ceramic material is a dark blue color. When the ceramic material contains chromium oxide or nickel oxide, the ceramic material is a dark green color. To obtain a gray ceramic material, a conductivity-imparting material containing titanium oxide may be added. To obtain a yellow ceramic material, a conductivity-imparting material containing zinc oxide may be added.

In many cases, the color of the electronic component 15 is generally white, silver, or gray. Thus, the vacuum suction nozzle 1 of black or a dark color is preferred. A specific example of the material in order to obtain the vacuum suction nozzle 1 of black is a ceramic material containing 65% by mass zirconia, 30% by mass iron oxide, 3% by mass cobalt oxide, and 2% by mass chromium oxide.
In the case of the electronic component 15 of silver, the vacuum suction nozzle 1 of a dark black color is preferred. A specific example of the material in order to obtain the vacuum suction nozzle 1 is a ceramic material containing 25% by mass or more iron oxide.

The ceramic material used for the vacuum suction nozzle 1 according to this embodiment is preferably zirconia containing a stabilizer with high mechanical strength.
The vacuum suction nozzle 1 (see Fig. 1(a)) according to this embodiment includes the elongated cylindrical portion 5 on the suction face 2 side. Thus, if the ceramic material used for the vacuum suction nozzle 1 has low mechanical strength, the cylindrical portion 5 is fragile. The vacuum suction nozzle 1 composed of the zirconia ceramic material with high mechanical strength has the advantage that the cylindrical portion 5 is not easily damaged.

Examples of the stabilizer that can be used include Y₂O₃ (yttria), CaO, CeO₂ (ceria), Dy₂O₃, Er₂O₃, and MgO (magnesia). In particular, the use of a compound containing yttrium (Y) as the stabilizer stabilizes the crystal phase of zirconia to further improve the mechanical properties and is thus preferable. With respect to the zirconia ceramic material, it is possible to obtain the zirconia ceramic material having sufficient mechanical strength as long as about 2% to 8% by mole of the stabilizer is contained. In addition, zirconia preferably has an average crystal grain size of 3 µm or less. At an average crystal grain size of zirconia of 3 µm or less, the crystal grains are not readily detached when the suction face 2 is subjected to grinding or mirror polishing to produce or repair the vacuum suction nozzle 1. Therefore, the suction face 2 is not readily chipped.

Particularly preferably, the vacuum suction nozzle 1 of the present invention is composed of a ceramic material that contains 65% to 80% by mass of zirconia containing the stabilizer and 20% to 35% by mass of iron oxide, chromium oxide, and titanium oxide, in total, as the conductivity-imparting material.

As described above, the zirconia ceramic material containing the stabilizer has high mechanical strength and thus is suited to produce the vacuum suction nozzle 1.
The use of iron oxide, chromium oxide, and titanium oxide as the conductivity-imparting material results in the suppression of the grain growth of the conductivity-imparting material during firing the ceramic material, thereby suppressing the detachment of grains and the chipping of edges when the suction face 2 is subjected to grinding.
The mechanism of the suppression of the grain growth of the conductivity-imparting material remains unclear. It is believed, however, that chromium oxide and titanium oxide react with impurities in iron oxide and zirconia to form compounds and that the resulting compound suppresses the grain growth of the conductivity-imparting material (in particular, the grain growth of iron oxide).

An amount of the conductivity-imparting material added of less than 20% by mass is unlikely to sufficiently reduce the volume resistivity of the ceramic material. An amount of the conductivity-imparting material added exceeding 35% by mass is liable to cause a reduction in the zirconia content of the ceramic material, thereby reducing the mechanical properties of the vacuum suction nozzle 1.

Furthermore, the conductivity-imparting material preferably contains 70% to 99.5% by mass iron oxide, 0.4% to 20% by mass chromium oxide, and 0.1% to 10% by mass titanium oxide. An iron oxide content of less than 70% by mass reduces the effect of decreasing the volume resistivity of the ceramic material. An iron oxide content exceeding 99.5% by mass results in excessively low proportions of chromium oxide and titanium oxide, thereby failing to suppress the grain growth of iron oxide during firing of the ceramic material. As a result, the vacuum suction nozzle 1 is liable to have reduced mechanical properties.

A titanium oxide content of less than 0.1% by mass fails to sufficiently reduce the proportion of the monoclinic crystal phase on the surface of the vacuum suction nozzle 1, which is liable to reduce the processability of the surface. A titanium oxide content exceeding 10% by mass causes the grain growth of zirconia, which is liable to reduce the mechanical properties of the vacuum suction nozzle 1.

A chromium oxide content of less than 0.4% by mass results in failure to suppress the grain growth of iron oxide during firing, which is liable to reduce the mechanical properties of the vacuum suction nozzle 1. A chromium oxide content exceeding 20% by mass results in a reduction in the sinterability of the zirconia ceramic material because of difficulty in the sintering of chromium oxide. Thus, a dense zirconia ceramic material is not obtained, which is liable to reduce the mechanical properties of the vacuum suction nozzle 1.

A method for producing the vacuum suction nozzle 1 will be specifically described below.
As the ceramic material constituting the vacuum suction nozzle 1, known material, for example, silicon carbide, alumina, or zirconia containing a stabilizer may be used. In the case of using alumina or zirconia containing a stabilizer, a conductivity-imparting material containing at least one of iron oxide, cobalt oxide, chromium oxide, and nickel oxide may be used. Alternatively, a conductivity-imparting material containing titanium carbide or titanium nitride may be used.
Two production examples of the vacuum suction nozzle 1 using each of the materials will be described below.

### A. Production Example of Vacuum Suction Nozzle 1 Using Silicon Carbide Ceramic Material

### <1. Preparation of Raw-Material Granules>

A raw material mixture of 95% by mass of silicon carbide and 5% by mass of alumina serving as a sintering agent is charged into a ball mill. The mixture is pulverized so as to have a predetermined particle size, forming a slurry. The slurry is spray-dried with a spray dryer to form granules.

### <2. Preparation of Pellets>

Next, the resulting granules and a thermoplastic resin are charged into a kneader and kneaded under heat. The resulting mixture is charged into a pelletizer to form pellets for use in injection molding. As the thermoplastic resin charged into the kneader, an ethylene-vinyl acetate copolymer, polystyrene, or an acrylic resin is suitable. The amount of the thermoplastic resin added is in the range of about 10% to about 25% by mass with respect to the mass of the ceramic material. The heating temperature when kneading is performed with the kneader is in the range of 140°C to 180°C. Furthermore, kneading conditions may be appropriately determined in response to the type and particle size of ceramic material and the type of thermoplastic resin.

### <3. Preparation of Formed Article>

The resulting pellets are charged into an injection molding machine and molded by injection molding to form a formed article of the vacuum suction nozzle 1. After a runner is separated from the resulting formed article, the formed article is calcined.

### <4. Sintering of Formed Article>

The formed article is sintered in a vacuum atmosphere or an inert gas atmosphere, e.g., argon or helium, at a maximum temperature of 1900°C to 2200°C for a holding time of 1 to 5 hours.
The sintering conditions can be changed in response to the conductivity-imparting material, imparting proper conductivity to the vacuum suction nozzle 1. For example, in the case where the conductivity-imparting material contains iron oxide, cobalt oxide, chromium oxide, and nickel oxide, sintering is performed in an air atmosphere at a maximum temperature of 1300°C to 1500°C for a holding time of 1 to 5 hours. In the case where the conductivity-imparting material is titanium carbide, sintering is performed in a vacuum atmosphere or an inert gas atmosphere at a maximum temperature of 1400°C to 1800°C for a holding time of 1 to 5 hours. In the case where the conductivity-imparting material is titanium nitride, sintering is performed in a vacuum atmosphere, an inert gas atmosphere, or a nitrogen atmosphere at a maximum temperature of 1400°C to 1800°C for a holding time of 1 to 5 hours.
The sintered vacuum suction nozzle 1 is polished by barrel finishing or the like. With respect to the assintered vacuum suction nozzle 1, physical properties of the surface (case) may be different from physical properties of the inside. Thus, removal of the surface results in the vacuum suction nozzle 1 having uniform physical properties.

### B. Production Example of Vacuum Suction Nozzle 1 Using Yttria-Stabilized Zirconia

### <1. Preparation of Raw-Material Granules>

A raw material mixture of 65% by mass of zirconia containing yttria serving as a stabilizer and 35% by mass of iron oxide is charged into a ball mill. The mixture is pulverized so as to have a predetermined particle size, forming a slurry. The slurry is spray-dried with a spray dryer to form granules.

### <2. Preparation of Pellets>

Next, the resulting granules and a thermoplastic resin are charged into a kneader and kneaded under heat. The resulting mixture is charged into a pelletizer to form pellets for use in injection molding.

### <3. Preparation of Formed Article>

The resulting pellets are charged into an injection molding machine and molded by injection molding to form a formed article of the vacuum suction nozzle 1. The resulting formed article is calcined.

### <4. Sintering of Formed Article>

The formed article is sintered in an air atmosphere at a maximum temperature of 1300°C to 1500°C for a holding time of 1 to 5 hours.

### EXAMPLE 1

### <Production of Samples 1 to 5>

Water was added to a raw-material mixture containing silicon carbide, alumina serving as a sintering agent, and carbon serving as a conductivity-imparting material (Tables 1-1 and 1-2 shows the mixture composition). The resulting mixture was pulverized and mixed with a ball mill to form a slurry. The slurry was spray-dried with a spray dryer to form granules. Then 20% by mass of an ethylene-vinyl acetate copolymer, polystyrene, and an acrylic resin, in total, with respect to 100% by mass of the granules were added to the granules. The resulting slurry was charged into a kneader and kneaded while being maintained at 150°C, forming a mixture. The resulting mixture was charged into a pelletizer to form pellets for use in injection molding. The resulting pellets were charged into a known injection molding machine to form formed articles to be formed into the vacuum suction nozzles 1 as shown in Fig. 1.

These formed articles were dried in a dryer filled with a nitrogen atmosphere and then sintered in an argon atmosphere at a maximum temperature of 1900°C to 2200°C for a holding time of 1 to 5 hours. The resulting sintered articles were subjected to barrel finishing, thereby removing the surface to a depth of several micrometers. Then a portion to be formed into the suction face 2 of each vacuum suction nozzle 1 was ground to form a plane, thereby affording the vacuum suction nozzle 1 including the cylindrical portion 5 having a length of 32 mm, an outer diameter of 0.7 mm, an inner diameter of 0.4 mm, and a thickness of 0.15 mm.

### <Production of Samples 6 to 14>

Water was added to a raw-material mixture containing alumina, titanium carbide serving as a conductivity-imparting material, and a sintering agent (appropriately selected from magnesia, calcia, titania, zirconia, and the like) (Tables 1-1 and 1-2 shows the mixture composition). The resulting mixture was pulverized and mixed with a ball mill to form a slurry. The slurry was spray-dried with a spray dryer to form granules. Then 20% by mass of an ethylene-vinyl acetate copolymer, polystyrene, and an acrylic resin, in total, with respect to 100% by mass of the granules were added to the granules. The resulting slurry was charged into a kneader and kneaded while being maintained at 150°C, forming a mixture. The resulting mixture was charged into a pelletizer to form pellets for use in injection molding. The resulting pellets were charged into a known injection molding machine to form formed articles to be formed into the vacuum suction nozzles 1 as shown in Fig. 1.

These formed articles were dried in a dryer and then sintered in an argon atmosphere at a maximum temperature of 1400°C to 1800°C for a holding time of 1 to 5 hours. The resulting sintered articles were subjected to barrel finishing, thereby removing the surface to a depth of several micrometers. Then a portion to be formed into the suction face 2 of each vacuum suction nozzle 1 was ground to form a plane, thereby affording the vacuum suction nozzle 1 including the cylindrical portion 5 having a length of 32 mm, an outer diameter of 0.7 mm, an inner diameter of 0.4 mm, and a thickness of 0.15 mm.

### <Production of Samples 15 to 22>

Water was added to a raw-material mixture containing zirconia containing 3% by mole yttria serving as a stabilizer, and iron oxide, cobalt oxide, chromium oxide, and nickel oxide serving as conductivity-imparting materials (Tables 1-1 and 1-2 shows the mixture composition). The resulting mixture was pulverized and mixed with a ball mill to form a slurry. The slurry was spray-dried with a spray dryer to form granules. Then 20% by mass of an ethylene-vinyl acetate copolymer, polystyrene, and an acrylic resin, in total, with respect to 100% by mass of the granules were added to the granules. The resulting slurry was charged into a kneader and kneaded while being maintained at 150°C, forming a mixture. The resulting mixture was charged into a pelletizer to form pellets for use in injection molding. The resulting pellets were charged into a known injection molding machine to form formed articles to be formed into the vacuum suction nozzles 1 as shown in Fig. 1.

These formed articles were dried in a dryer and then sintered in an air atmosphere at a maximum temperature of 1300°C to 1500°C for a holding time of 1 to 5 hours. The resulting sintered articles were subjected to barrel finishing, thereby removing the surface to a depth of several micrometers. Then a portion to be formed into the suction face 2 of each vacuum suction nozzle 1 was ground to form a plane, thereby affording the vacuum suction nozzle 1 including the cylindrical portion 5 having a length of 32 mm, an outer diameter of 0.7 mm, an inner diameter of 0.4 mm, and a thickness of 0.15 mm.

### <Evaluation Test of Samples 1 to 22>

Resistance values of samples 1 to 22 of the vacuum suction nozzles 1 were measured. Tables 1-1 and 1-2 show the test results. The results demonstrated that samples 1 to 4, 7 to 12, and 16 to 21 were defined as the vacuum suction nozzles 1 of the present invention and that samples 5, 6, 13 to 15, and 22 were defined as the vacuum suction nozzles 1 outside the range of the present invention (that is, Comparative Examples).

Each of samples 1 to 22 of the vacuum suction nozzles 1 was practically attached to the electronic component mounting device 14, and then a transport test of the electronic components 15 was performed (in order to check the occurrence of the blowing off of the electronic components 15 and to check the occurrence of damage to the electronic components 15 by electrostatic discharge). As the electronic components 15, 0603-type components (dimensions: 0.6 mm × 0.3 mm) were used. The minimum mounting spacing between the electronic components 15 on a circuit board was set to 0.1 mm.

The occurrence of the blowing off of the electronic components 15 was checked as follows: Twenty million electronic components 15 were transported onto dummy boards. After completion of the transport, the number of the electronic components 15 on the dummy boards was counted to determine the number of the electronic components 15 blown off. Tables 1-1 and 1-2 show the test results. The symbols were defined as follows: A: the number of the electronic components blown off was 3 or less; B: 4 to 10; and C: 11 or more. Note that when the vacuum suction nozzle 31 of the related art was used, the number of the electronic components blown off was about 11.

Furthermore, the occurrence of damage to the electronic components 15 by electrostatic discharge was checked as follows: Twenty million electronic components 15 were transported and mounted onto dummy boards including circuits. After completion of the mounting, damage to the electronic components 15 by electrostatic discharge was checked by energizing the circuits of the dummy boards. In this test, 100 electronic components 15 were mounted on one dummy board. A continuity test was performed for each dummy board with a common circuit tester. The dummy boards through which a current did not flow were selected. The continuity test was performed for each electronic component 15 to count the number of the electronic components 15 damaged by electrostatic discharge. Tables 1-1 and 1-2 show the test results. The symbols were defined as follows: A: the number of the electronic components damaged by electrostatic discharge was 3 or less; B: 4 to 10; and C: 11 or more. Note that when the vacuum suction nozzle 31 of the related art was used, the number of the electronic components damaged by electrostatic discharge was about 11.

**Table 1-1**

| Sample | Ceramic material | Resistance between front end and rear end (Ω) | Conductivity-imparting material | | | | | | | Sintering agent | Damage by electrostatic discharge | Blowing off of object to be sucked | Color of vacuum suction nozzle |
|---|---|---|---|---|---|---|---|---|---|---|---|---|---|
| | | | Total of conductivity-imparting material | Iron oxide | Cobalt oxide | Chromium oxide | Nickel oxide | Titanium carbide | Carbon | | | | |
| | | | % by mass | | | | | | | | | | |
| 1 | Silicon carbide | 10⁶ | 0 | 0 | 0 | 0 | 0 | 0 | <0.1 | 5 | A | A | Black |
| 2 | Silicon carbide | 10⁵ | 0.2 | 0 | 0 | 0 | 0 | 0 | 0.2 | 5 | A | A | Black |
| 3 | Silicon carbide | 10⁴ | 1 | 0 | 0 | 0 | 0 | 0 | 1 | 5 | B | A | Black |
| 4 | Silicon carbide | 10³ | 3 | 0 | 0 | 0 | 0 | 0 | 3 | 5 | B | A | Black |
| *5 | Silicon carbide | 10² | 4 | 0 | 0 | 0 | 0 | 0 | 4 | 5 | C | A | Black |
| *6 | Alumina | 10¹² | 0 | 0 | 0 | 0 | 0 | 0 | 0 | 0.5 | B | C | White |
| 7 | Alumina | 10¹¹ | 3 | 0 | 0 | 0 | 0 | 3 | 0 | 1 | B | B | Gray |
| 8 | Alumina | 10⁹ | 5 | 0 | 0 | 0 | 0 | 5 | 0 | 1 | A | B | Black |
| 9 | Alumina | 10⁸ | 8 | 0 | 0 | 0 | 0 | 8 | 0 | 2 | A | A | Black |
| 10 | Alumina | 10⁵ | 13 | 0 | 0 | 0 | 0 | 13 | 0 | 4 | A | A | Black |
| 11 | Alumina | 10⁴ | 15 | 0 | 0 | 0 | 0 | 15 | 0 | 4 | B | A | Black |
| 12 | Alumina | 10³ | 17 | 0 | 0 | 0 | 0 | 17 | 0 | 5 | B | A | Black |

| | | | | | | | | | | | | | |
|---|---|---|---|---|---|---|---|---|---|---|---|---|---|
| Samples with asterisks are outside the range of the present invention. | | | | | | | | | | | | | |

**Table 1-2**

| Samples | Ceramic material | Resistance between front end and rear end (Ω) | Conductivity-imparting material | | | | | | | Sintering agent | Damage by electrostatic discharge | Blowing off of object to be sucked | Color of vacuum suction nozzle |
|---|---|---|---|---|---|---|---|---|---|---|---|---|---|
| | | | Total of conductivity-imparting material | Iron oxide | Cobalt oxide | Chromium oxide | Nickel oxide | Titanium carbide | Carbon | | | | |
| | | | % by mass | | | | | | | | | | |
| *13 | Alumina | 10² | 19 | 0 | 0 | 0 | 0 | 19 | 0 | 5 | C | A | Black |
| *14 | Alumina | 10⁻³ | 29 | 0 | 0 | 0 | 0 | 29 | 0 | 6 | C | A | Black |
| *15 | Zirconia | 10¹² | 0 | 0 | 0 | 0 | 0 | 0 | 0 | 0 | B | C | White |
| 16 | Zirconia | 10¹¹ | 28 | 23 | 2 | 2 | 1 | 0 | 0 | 0 | B | B | Black |
| 17 | Zirconia | 10⁹ | 32 | 27 | 2 | 2 | 1 | 0 | 0 | 0 | A | B | Black |
| 18 | Zirconia | 10⁸ | 34 | 29 | 2 | 2 | 1 | | 0 | 0 | A | A | Black |
| 19 | Zirconia | 10⁷ | 36 | 31 | 2 | 2 | 1 | 0 | 0 | 0 | A | A | Black |
| 20 | Zirconia | 10⁵ | 41 | 36 | 2 | 2 | 1 | 0 | 0 | 0 | A | A | Black |
| 21 | Zirconia | 10³ | 45 | 40 | 2 | 2 | 1 | 0 | 0 | 0 | B | A | Black |
| *22 | Zirconia | 10² | 50 | 45 | 2 | 2 | 1 | 0 | 0 | 0 | C | A | Black |

| | | | | | | | | | | | | | |
|---|---|---|---|---|---|---|---|---|---|---|---|---|---|
| Samples with asterisks are outside the range of the present invention. | | | | | | | | | | | | | |

The results shown in Tables 1-1 and 1-2 demonstrated that in both cases of studying the occurrence of the blowing off of the electronic components 15 and the occurrence of damage by electrostatic discharge, satisfactory results were obtained when the vacuum suction nozzles 1 had resistances of 10³ to 10¹¹ Ω (samples 1 to 4, 7 to 12, and 16 to 21). In particular, when the vacuum suction nozzles 1 had resistances of 10⁵ to 10⁸ Q (samples 1, 2, 9, 10, and 18 to 20), the number of the electronic components 15 damaged by electrostatic discharge and the number of the electronic components 15 blown off were each 3 or less, which was very good result.

In contrast, when the vacuum suction nozzles 1 had resistances of less than 10³ Ω (samples 5, 13, 14, and 22), the results of the occurrence of damage by electrostatic discharge were poor. When vacuum suction nozzles 1 had resistances exceeding 10¹¹ Ω (samples 6 and 15), the results of the occurrence of the blowing off were poor.

These results demonstrated that the vacuum suction nozzle 1 having a resistance of 10³ to 10¹¹ Ω had the effect of suppressing the blowing off of the electronic components 15 and damage to the electronic components 15 by electrostatic discharge. In particular, it was found that when the vacuum suction nozzle 1 had a resistance of 10⁵ to 10⁸ Ω, the effect was high.

### EXAMPLE 2

### <Production of Samples 23 to 28>

The relationship between the dimension (diameter) of the suction face 2 of the vacuum suction nozzle 1 and the damage of the suction face 2 was studied. For a test, the vacuum suction nozzles 1 having the suction faces 2 with different diameters (samples 23 to 28) were produced. A production procedure was the same as in Example 1. The suction faces 2 were circular. Table 2 shows the diameter of the suction face 2 of each sample. Note that the composition of each vacuum suction nozzle 1 was the same as in sample 17 in Example 1 (see Tables 1-1 and 1-2).

### <Evaluation Test of Samples 23 to 28>

A damage test of the suction face 2 was performed using samples 23 to 28 of the vacuum suction nozzles 1. Each vacuum suction nozzle 1 was attached to the electronic component mounting device 14, and then 35-million 0603-type electronic components 15 (dimensions: 0.6 mm x 0.3 mm) were transported. The suction face 2 of the vacuum suction nozzle 1 was observed for every 5-million electronic components 15 with an optical microscope (50× magnification) to determine the presence or absence of damage to the suction face 2. The minimum mounting spacing between the electronic components 15 on a circuit board was set to 0.1 mm. Table 2 shows the test results. The symbols were defined as follows: A: the suction face 2 was not damaged on transporting even when 35-million electronic components were transported; B: damage to the suction face 2 occurred on transporting 25- to 30-million electronic components; C: damage to the suction face 2 occurred on transporting 20- to 25-million electronic components; and D: damage to the suction face 2 occurred on transporting less than 20-million electronic components. Note that when the vacuum suction nozzle 31 of the related art was used, damage to the suction face 2 occurred on transporting less than 20-million electronic components.

**Table 2**

| Sample | Outer diameter of (cylindrical portion (mm) | Damage to suction face |
|---|---|---|
| *23 | 1.2 | D |
| *24 | 1.0 | C |
| *25 | 0.8 | C |
| 26 | 0.7 | B |
| 27 | 0.6 | A |
| 28 | 0.5 | A |

| | | |
|---|---|---|
| Samples with asterisks are outside the range of the present invention. | | |

The results shown in Table 2 demonstrated that a diameter of the suction face 2 of 0.7 mm or less (samples 26 to 28) provided satisfactory results. In particular, at a diameter of the suction face 2 of 0.6 mm or less (samples 27 and 28), the suction face 2 was not damaged even when 35-million electronic components were transported.
In contrast, a diameter of the suction face 2 exceeding 0.7 mm (samples 23 to 25) did not provide satisfactory results.
The results demonstrated that the vacuum suction nozzle 1 having the suction face 2 with a diameter of 0.7 mm or less was suited to transport the small electronic components 15, e.g., 0603-type, onto a circuit board.

### EXAMPLE 3

The relationship between the color of the vacuum suction nozzle 1 and the accuracy of position measurement of the electronic component 15 was studied.
In a position measurement test, samples 17 (black), 10 (black), and 15 (white) of the vacuum suction nozzles 1 produced in Example 1 were used. The compositions of samples are shown in Tables 1-1 and 1-2. In this test, test chips of five colors, black, blue, red, yellow, and white, were used in place of the electronic components 15.

In the position measurement test, the electronic component mounting apparatus 20 shown in Fig. 2 was used. The electronic component mounting apparatus 20 includes the electronic component mounting device 14 to which the vacuum suction nozzle 1 is fixed and the measurement optical system for analyzing the position of each test chip. The measurement optical system includes the lights 17, the CCD camera 18, and the image analysis device 19 connected to the CCD camera 18. The lights 17 emit light to the test chip sucked by the vacuum suction nozzle 1. The test chip is photographed by the CCD camera 18. The resulting image is analyzed by the image analysis device 19. The electronic component mounting device 14 arranges the test chip at a predetermined position of a circuit board on the basis of the analysis result.

In the position measurement test, first, the vacuum suction nozzle 1 for the test was attached to the electronic component mounting device 14 and sucked the test chip. The test chip was photographed with the CCD camera 18. Whether the CCD camera 18 can discriminate between the test chip and the vacuum suction nozzle 1 (recognizability) or not was checked. Then whether the test chip can be arranged at the predetermined position of the circuit board or not was checked.

When black samples 10 and 17 of the vacuum suction nozzles 1 were used, satisfactory discrimination was provided in all test chips of five colors. Furthermore, all test chips of five colors were assuredly arranged at the predetermined positions of the circuit board.

In contrast, when white sample 15 of the vacuum suction nozzle 1 was used, satisfactory discrimination was provided in the test chips of four colors other than white. For the white test chip, discrimination seems to be reduced because of a low contrast between the test chip and the vacuum suction nozzle 1. The test chips of four colors other than white were assuredly arranged at the predetermined positions of the circuit board.

### EXAMPLE

### <Samples 29 to 31>

The relationship between the type of ceramic material constituting the vacuum suction nozzle 1 and the damage to the suction face 2 was studied. For this test, the vacuum suction nozzles 1 the same as samples 10 (alumina based), 20 (stabilized zirconia based), and 2 (silicon carbide based) in Example 1 were newly produced and referred to as samples 29 to 31 (see Table 3). The suction faces 2 were circular. Each of the suction faces 2 had an outer diameter of 0.7 mm.

### <Evaluation Test of Samples 29 to 31>

A damage test of the suction face 2 was performed using samples 29 to 31 of the vacuum suction nozzles 1. Each vacuum suction nozzle 1 was attached to the electronic component mounting device 14, and then 35-million 0603-type electronic components 15 (dimensions: 0.6 mm x 0.3 mm) were transported. Each vacuum suction nozzle 1 was attached to the electronic component mounting device 14, and then 35-million 0603-type electronic components 15 (dimensions: 0.6 mm x 0.3 mm) were transported. The suction face 2 of the vacuum suction nozzle 1 was observed for every 5-million electronic components 15 with an optical microscope (50× magnification) to determine the presence or absence of damage to the suction face 2. The minimum mounting spacing between the electronic components on a circuit board was set to 0.1 mm. Table 3 shows the test results. The symbols were defined as follows: A: the suction face 2 was not damaged on transporting even when 35-million electronic components were transported; B: damage to the suction face 2 occurred on transporting 25- to 30-million electronic components; C: damage to the suction face 2 occurred on transporting 20- to 25-million electronic components; and D: damage to the suction face 2 occurred on transporting less than 20-million electronic components. Note that when the vacuum suction nozzle 31 of the related art was used, damage to the suction face 2 occurred on transporting less than 20-million electronic components.

**Table 3**

| Sample | Sample in Table 1 | Ceramic material | Damage to suction face |
|---|---|---|---|
| 29 | 10 | Alumina | B |
| 30 | 18 | Zirconia | A |
| 31 | 2 | Silicon carbide | B |

The results shown in Table 3 demonstrated that in sample 30 (stabilized zirconia based), the suction face 2 was not damaged even when 35-million electronic components were transported. In contrast, in each of samples 29 (alumina based) and 31 (silicon carbide based), damage to the suction face 2 occurred on transporting 25- to 30-million electronic components. The results demonstrated that when the vacuum suction nozzle 1 was composed of a stabilizer-containing zirconia-based ceramic material, the vacuum suction nozzle 1 had good mechanical strength. The reason for this is believed that zirconia has a higher toughness than alumina or silicon carbide.

### EXAMPLE 5

### <samples 32 to 66>

Evaluation was made on the size of a chip formed when the suction face 2 of the vacuum suction nozzle 1 was subjected to grinding. A smaller chip results in higher form accuracy of an end face 70 and thus is preferred.
For a test, the vacuum suction nozzles 1 having compositions shown in Tables 4-1 to 4-3 were produced. In Tables, "zirconia" indicates zirconia containing 3% by mole yttria serving as a stabilizer. A procedure of forming samples was the same as in Example 1. The suction faces 2 were circular. Each of the suction faces 2 had an outer diameter of (diameter of each suction face 2) 0.7 mm.

### <Evaluation Test of Samples 32 to 66>

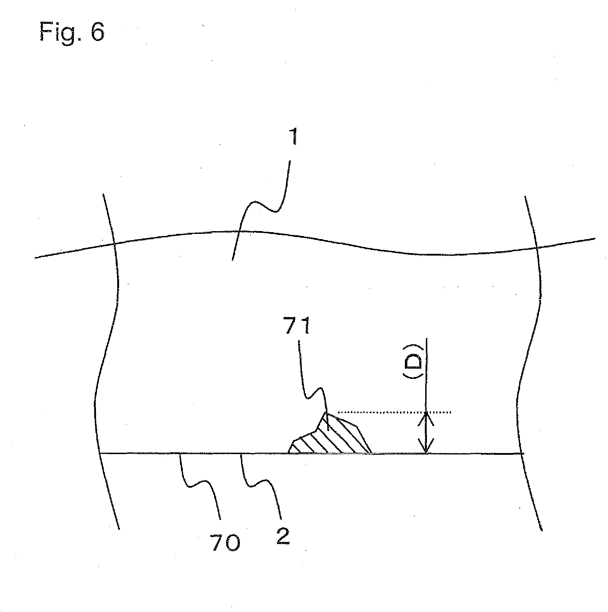

A #325 electrodeposited grinding wheel was used for grinding of the suction face 2. A method for evaluating a chip is described with reference to Fig. 6. The end face 70 of the suction face 2 of the vacuum suction nozzle 1 was observed with a factory microscope at a magnification of 100× to determine the depth D of a chip 71 (hatched portion). Tables 4-1 to 4-3 show the test results. The symbols were defined as follows: A: the maximum value of the depth D was 30 µm or less; B: more than 30 µm and 50 µm or less; and C: more than 50 µm.

**Table 4-1**

| Sample | Zirconia (% by mass | Total amount of iron oxide, chromium oxide, and titanium oxide (% by mass) | Iron oxide content (%) | Chromium oxide content (%) | Titanium oxide content (%) | Resistance (Ω) | Chipping of end face |
|---|---|---|---|---|---|---|---|
| *32 | 95 | 5 | 100 | 0 | 0 | ≥ 10¹² | A |
| *33 | 90 | 10 | 99.5 | 0.4 | 0.1 | ≥ 10¹² | A |
| *34 | 85 | 15 | 99.5 | 0.4 | 0.1 | ≥ 10¹² | A |
| 35 | 80 | 20 | 100 | 0 | 0 | 10¹⁰ | B |
| 36 | 80 | 20 | 99.6 | 0.4 | 0 | 10¹⁰ | B |
| 37 | 80 | 20 | 99.5 | 0.5 | 0 | 10¹⁰ | B |
| 38 | 80 | 20 | 99.5 | 0.3 | 0.2 | 10¹⁰ | B |
| 39 | 80 | 20 | 99.5 | 0.4 | 0.1 | 10¹⁰ | A |
| 40 | 80 | 20 | 90 | 9 | 1 | 10¹⁰ | A |
| 41 | 80 | 20 | 80 | 15 | 5 | 10¹¹ | A |
| 42 | 80 | 20 | 70 | 20 | 10 | 10¹¹ | A |
| 43 | 80 | 20 | 70 | 25 | 5 | 10¹¹ | B |
| 44 | 80 | 20 | 70 | 15 | 15 | 10¹¹ | B |
| *45 | 80 | 20 | 65 | 20 | 15 | ≥ 10¹² | B |

| | | | | | | | |
|---|---|---|---|---|---|---|---|
| Samples with asterisks are outside the range of the present invention. | | | | | | | |

**Table 4-2**

| Sample | Zirconia (% by mass) | Total amount of iron oxide, chromium oxide, and titanium oxide (% by mass) | Iron oxide content (%) | Chromium oxide content (%) | Titanium oxide content (%) | Resistance (Ω) | Chipping of end face |
|---|---|---|---|---|---|---|---|
| 46 | 70 | 30 | 99.6 | 0.4 | 0 | 10⁶ | B |
| 47 | 70 | 30 | 99.5 | 0.5 | 0 | 10⁶ | B |
| 48 | 70 | 30 | 99.5 | 0.3 | 0.2 | 10⁶ | B |
| 49 | 70 | 30 | 99.5 | 0.4 | 0.1 | 10⁶ | A |
| 50 | 70 | 30 | 90 | 9 | 1 | 10⁶ | A |
| 51 | 70 | 30 | 80 | 15 | 5 | 10⁷ | A |
| 52 | 70 | 30 | 70 | 20 | 10 | 10⁷ | A |
| 53 | 70 | 30 | 70 | 25 | 5 | 10⁷ | B |
| 54 | 70 | 30 | 70 | 15 | 15 | 10⁷ | B |
| 55 | 65 | 35 | 99.6 | 0.4 | 0 | 10⁶ | B |
| 56 | 65 | 35 | 99.5 | 0.5 | 0 | 10⁶ | B |
| 57 | 65 | 35 | 99.5 | 0.3 | 0.2 | 10⁶ | B |
| 58 | 65 | 35 | 99.5 | 0.4 | 0.1 | 10⁶ | A |
| 59 | 65 | 35 | 90 | 9 | 1 | 10⁶ | A |
| 60 | 65 | 35 | 80 | 15 | 5 | 10⁷ | A |

| | | | | | | | |
|---|---|---|---|---|---|---|---|
| Samples with asterisks are outside the range of the present invention. | | | | | | | |

**Table 4-3**

| Sample | Zirconia (% by mass) | Total amount of iron oxide, chromium oxide, and titanium oxide (% by mass) | Iron oxide content (%) | Chromium oxide content (%) | Titanium oxide content (%) | Resistance (Ω) | Clipping of end face |
|---|---|---|---|---|---|---|---|
| 61 | 65 | 35 | 70 | 20 | 10 | 10⁷ | A |
| 62 | 65 | 35 | 70 | 25 | 5 | 10⁷ | B |
| 63 | 65 | 35 | 70 | 15 | 15 | 10⁷ | B |
| 64 | 60 | 40 | 90 | 9 | 1 | 10⁴ | B |
| 65 | 60 | 40 | 90 | 9 | 1 | 10⁴ | B |
| 66 | 60 | 40 | 80 | 15 | 5 | 10⁵ | B |
| 2 | Silicon carbide | 0.2 | - | - | - | 10⁵ | B |
| 10 | Alumina | 13 | - | - | - | 10⁵ | B |
| 20 | 59 | 41 | 88 | 5 | 0 | 10⁵ | B |

| | | | | | | | |
|---|---|---|---|---|---|---|---|
| Samples with asterisks are outside the range of the present invention. | | | | | | | |

The results shown in Tables 4-1 to 4-3 demonstrated that samples 39 to 42, 49 to 52, and 58 to 61 were the best because the depth D of the chip was 30 µm or less. Each of the samples was composed of 65% to 80% by mass of zirconia and 20% to 35% by mass of the conductivity-imparting material (iron oxide, chromium oxide, and titanium oxide). Furthermore, each of the conductivity-imparting materials had an iron oxide content of 70% to 99.5%, a chromium oxide content of 0.4% to 20%, and titanium oxide content of 0.1% to 10%. In general, an increased depth of the chip 71 seems to be attributed to the grain growth of zirconia and iron oxide. Each of the samples had appropriate proportions of the constituents, thus probably suppressing the grain growth of zirconia and iron oxide.

Each of samples 35 to 38, 43, 44, 46 to 48, 53 to 57, 62 to 66, 2, 10, and 20 had a depth D of 30 µm to 50 µm, which was a satisfactory result.

Each of samples 32 to 34 had a depth D of the chip of 30 µm or less, which was a good result. Furthermore, sample 45 had a depth D of the chip of 50 µm or less, which was a satisfactory result. However, in these samples, each of the vacuum suction nozzles 1 had a resistance of 10¹² Ω or more, which may cause a problem of charging.

### EXAMPLE 6

In the case where high-speed mounting was performed, the blowing off of the electronic components 15 and damage to the electronic components 15 by electrostatic discharge were studied. For a test, samples 1 to 4, 7 to 11, and 17 to 20 of the vacuum suction nozzles 1 produced in Example 1 were used.

The mounting speed was defined as the number of the electronic components 15 transported per hour (chip per hour, hereinafter referred to as "CPH"). In this experiment, the mounting speed was set at 4500 CPH (attachment-detachment cycle: 0.8 seconds), 7200 CPH (attachment-detachment cycle: 0.5 seconds), 12,000 CPH (attachment-detachment cycle: 0.3 seconds), 18,000 CPH (attachment-detachment cycle: 0.2 seconds), or 20,000 CPH (attachment-detachment cycle: 0.18 seconds).

The occurrence of the blowing off of the electronic components 15 was checked as follows: Twenty million electronic components 15 were transported onto dummy boards. After completion of the transport, the number of the electronic components 15 on the dummy boards was counted to determine the number of the electronic components 15 blown off. Tables 5-1 to 5-3 show the test results. The symbols were defined as follows: A: the number of the electronic components blown off was 3 or less; B: 4 to 10; and C: 11 or more.

Furthermore, the occurrence of damage to the electronic components 15 by electrostatic discharge was checked as follows: Twenty million electronic components 15 were transported and mounted onto dummy boards including circuits. After completion of the mounting, damage to the electronic components 15 by electrostatic discharge was checked by energizing the circuits of the dummy boards. A method for measuring damage by electrostatic discharge was the same as in Example 1. Tables 5-1 to 5-3 show the test results. The symbols were defined as follows: A: the number of the electronic components damaged by electrostatic discharge was 3 or less; B: 4 to 10; and C: 11 or more.

**Table 5-1**

| Sample | Ceramic material | Resistance between front end and rear end (Ω) | Mounting speed (CPH) | Damage by electrostatic discharge | Blowing off of object to be sucked |
|---|---|---|---|---|---|
| 1 | Silicon carbide | 10⁶ | 20000 | A | A |
| | | | 18000 | A | A |
| | | | 12000 | A | A |
| | | | 7200 | A | A |
| | | | 4500 | A | A |
| 2 | Silicon carbide | 10⁵ | 20000 | A | A |
| | | | 18000 | A | A |
| | | | 12000 | A | A |
| | | | 7200 | A | A |
| | | | 4500 | A | A |
| 3 | Silicon carbide | 10⁴ | 20000 | B | A |
| | | | 18000 | B | A |
| | | | 12000 | B | A |
| | | | 7200 | A | A |
| | | | 4500 | A | A |
| 4 | Silicon carbide | 10³ | 20000 | B | A |
| | | | 18000 | B | A |
| | | | 12000 | B | A |
| | | | 7200 | B | A |
| | | | 4500 | A | A |
| 7 | Alumina | 10¹¹ | 20000 | A | B |
| | | | 18000 | A | B |
| | | | 12000 | A | B |
| | | | 7200 | A | A |
| | | | 4500 | A | A |

**Table 5-2**

| Sample | Ceramic material | Resistance between front end and rear end (Ω) | Mounting speed (CPH) | Damage by electrostatic discharge | Blowing off of object to be sucked |
|---|---|---|---|---|---|
| 8 | Alumina | 10⁹ | 20000 | A | B |
| | | | 18000 | A | B |
| | | | 12000 | A | A |
| | | | 7200 | A | A |
| | | | 4500 | A | A |
| 9 | Alumina | 10⁸ | 20000 | A | A |
| | | | 18000 | A | A |
| | | | 12000 | A | A |
| | | | 7200 | A | A |
| | | | 4500 | A | A |
| 10 | Alumina | 10⁵ | 20000 | A | A |
| | | | 18000 | A | A |
| | | | 12000 | A | A |
| | | | 7200 | A | A |
| | | | 4500 | A | A |
| 11 | Alumina | 10⁴ | 20000 | B | A |
| | | | 18000 | B | A |
| | | | 12000 | B | A |
| | | | 7200 | A | A |
| | | | 4500 | A | A |
| 17 | Zirconia | 10⁹ | 20000 | A | B |
| | | | 18000 | A | B |
| | | | 12000 | A | A |
| | | | 7200 | A | A |
| | | | 4500 | A | A |

**Table 5-3**

| Sample | Ceramic material | Resistance between front end and rear end (Ω) | Mounting speed (CPH) | Damage by electrostatic discharge | Blowing off of object to be sucked |
|---|---|---|---|---|---|
| 18 | Zirconia | 10⁸ | 20000 | A | A |
| | | | 18000 | A | A |
| | | | 12000 | A | A |
| | | | 7200 | A | A |
| | | | 4500 | A | A |
| 19 | Zirconia | 10⁷ | 20000 | A | A |
| | | | 18000 | A | A |
| | | | 12000 | A | A |
| | | | 7200 | A | A |
| | | | 4500 | A | A |
| 20 | Zirconia | 10⁵ | 20000 | A | A |
| | | | 18000 | A | A |
| | | | 12000 | A | A |
| | | | 7200 | A | A |
| | | | 4500 | A | A |

The results shown in Tables 5-1 to 5-3 demonstrated that in each of the studies of the occurrence of the blowing off of the electronic components 15 and the occurrence of damage to the electronic components 15 by electrostatic discharge, a resistance of the vacuum suction nozzle 1 of 10³ to 10¹¹ Ω (samples 1 to 4, 7 to 11, and 17 to 20) provided relatively good results. In particular, when the vacuum suction nozzle 1 had a resistance of 10⁵ to 10⁸ Ω (samples 1, 2, 9, 10, and 18 to 20), very good results were obtained in all mounting speeds. These results demonstrated that the vacuum suction nozzle 1 having a resistance of 10⁵ to 10⁸ Ω made it possible to correspond to a higher mounting speed.

Samples 3 and 11 provided good results for the blowing off of the object to be sucked in all mounting speeds. With respect to damage by electrostatic discharge, however, in these samples, the number of the electronic components damaged tends to increase at a mounting speed of 12,000 CPH or more. The reason for this is believed as follows: These samples have a relatively low resistance of 10⁴ Ω. Thus, at a higher mounting speed, discharge occurs readily from an electrostatically charged member around the vacuum suction nozzle 1 to the front end of the vacuum suction nozzle 1 and the sucked electronic component 15.

Furthermore, samples 8 and 17 provided good results for damage by electrostatic discharge in all mounting speeds. With respect to the blowing off of the object to be sucked, however, in these samples, the number of the electronic components tends to increase at a mounting speed of 18,000 CPH or more. The reason for this is believed as follows: These samples have a relatively high resistance of 10⁹ Ω. Thus, static electricity is not sufficiently removed at a higher mounting speed, thereby increasing the electrostatic repulsion acting between the vacuum suction nozzle 1 and the electronic components 15.

The above-described examples demonstrated that the vacuum suction nozzle 1 of the present invention was not readily charged and thus was not susceptible to static electricity when it was fixed to the electronic component mounting apparatus 20 and then transported the electronic components 15; hence, the vacuum suction nozzle 1 had the effect of suppressing the blowing off of the electronic components 15 by the electrostatic repulsion acting between the vacuum suction nozzle 1 and the electronic components 15. Furthermore, the results demonstrated that the vacuum suction nozzle 1 had the effect of suppressing damage to the electronic components 15 by electrostatic discharge.
Moreover, the results demonstrated that the vacuum suction nozzle 1 composed of the zirconia ceramic material containing the stabilizer suppressed damage to the suction face 2.
In addition, the results demonstrated that appropriate selection of the color of the vacuum suction nozzle 1 resulted in the accurate mounting of the electronic components 15 on predetermined positions of circuit boards.

## Claims

1. A vacuum suction nozzle composed of a ceramic material, comprising:
a suction face;
a rear end face opposite the suction face; and
a suction hole extending from the suction face to the rear end face,
wherein the vacuum suction nozzle has a resistance of 10³ to 10¹¹ Ω between the suction face and the rear end face.

2. The vacuum suction nozzle according to Claim 1, wherein the suction face has a maximum dimension of 0.7 mm or less in at least one of a first direction and a second direction directed toward the first direction.

3. The vacuum suction nozzle according to Claim 1, wherein the resistance is in the range of 10⁵ to 10⁸ Ω.

4. The vacuum suction nozzle according to Claim 1, wherein the vacuum suction nozzle is composed of a ceramic material that contains a conductivity-imparting material.

5. The vacuum suction nozzle according to Claim 1, wherein a side face of the vacuum suction nozzle is covered with a conductive layer, and
wherein the conductive layer is composed of a conductivity-imparting material or a ceramic material that contains a conductivity-imparting material.

6. The vacuum suction nozzle according to Claim 5, wherein the conductive layer is composed of a precipitate from the vacuum suction nozzle.

7. The vacuum suction nozzle according to Claim 5, wherein the conductive layer is formed by coating.

8. The vacuum suction nozzle according to Claim 1, wherein the vacuum suction nozzle is composed of a black ceramic material.

9. The vacuum suction nozzle according to Claim 1, wherein the vacuum suction nozzle is composed of zirconia that contains a stabilizer.

10. The vacuum suction nozzle according to Claim 4, wherein the conductivity-imparting material contains at least one of iron oxide, cobalt oxide, chromium oxide, and nickel oxide.

11. The vacuum suction nozzle according to Claim 4, wherein the conductivity-imparting material contains titanium oxide.

12. The vacuum suction nozzle according to Claim 4, wherein the conductivity-imparting material contains zinc oxide.

13. The vacuum suction nozzle according to Claim 1 or 4, wherein the vacuum suction nozzle is composed of a ceramic material that contains
65% to 80% by mass zirconia containing a stabilizer, and
20% to 35% by mass iron oxide, chromium oxide, or titanium oxide.

## Amended claims

### Amended claims under Art. 19.1 PCT

**1.** (Amended) A vacuum suction nozzle composed of a ceramic material, comprising:
a suction face for vacuum-sucking an object to be sucked;
a rear end face opposite the suction face; and
a suction hole extending from the suction face to the rear end face,
wherein a side face of the vacuum suction nozzle is covered with a conductive layer,
the conductive layer is composed of a precipitate from the ceramic material constituting the vacuum suction nozzle, and
the vacuum suction nozzle has a resistance of 10³ to 10¹¹ Ω between the suction face and the rear end face.

**2.** (Amended) The vacuum suction nozzle according to Claim 1, wherein the suction face has a maximum dimension of 0.7 mm or less in at least one of a first direction and a second direction orthogonal to the first direction.

**3.** The vacuum suction nozzle according to Claim 1, wherein the resistance is in the range of 10⁵ to 10⁸ Ω.

**4.** The vacuum suction nozzle according to Claim 1, wherein the vacuum suction nozzle is composed of the ceramic material that contains a conductivity-imparting material.

**5.** (Amended) The vacuum suction nozzle according to Claim 1, wherein the conductive layer is composed of a conductivity-imparting material or a ceramic material that contains a conductivity-imparting material.

**6.** (Cancelled)

**7.** (Cancelled)

**8.** The vacuum suction nozzle according to Claim 1, wherein the vacuum suction nozzle is composed of a black ceramic material.

**9.** The vacuum suction nozzle according to Claim 1, wherein the vacuum suction nozzle is composed of zirconia that contains a stabilizer.

**10.** The vacuum suction nozzle according to Claim 4, wherein the conductivity-imparting material contains at least one of iron oxide, cobalt oxide, chromium oxide, and nickel oxide.

**11.** The vacuum suction nozzle according to Claim 4, wherein the conductivity-imparting material contains titanium oxide.

**12.** The vacuum suction nozzle according to Claim 4, wherein the conductivity-imparting material contains zinc oxide.

**13.** The vacuum suction nozzle according to Claim 1 or 4, wherein the vacuum suction nozzle is composed of a ceramic material that contains
65% to 80% by mass zirconia containing a stabilizer, and
20% to 35% by mass iron oxide, chromium oxide, or titanium oxide.
